# DEMANDE DE BREVET EUROPEEN

(11) **EP 0 865 045 A1**
(43) Date de publication de la demande: **16.09.1998**
(21) Numéro de dépôt: 98400566.0
(22) Date de dépôt: 11.03.1998
(51) Int. Cl.: G11C 16/04

(54) **Procédé de mémorisation électrique non volatile d'un bit, et dispositif de mémoire correspondant**

(30) Priorité: 12.03.1997 FR 9702943
(71) Demandeur: Mixed Silicon Structures, 59100 Roubaix (FR)
(72) Inventeur: Op't Eynde, Frank, 3010 Kessel-Lo (BE)
(74) Mandataire: Casalonga, Axel

(57) **Abrégé**

Le dispositif de mémoire morte programmable et effaçable électriquement, comprend au moins une cellule de mémorisation (CM) programmable et effaçable par effet tunnel comportant un transistor principal (M1) relié à un circuit capacitif. Le transistor principal (M1) est encaissonné dans un substrat semi-conducteur. Le circuit capacitif comporte une première et une deuxième capacités distinctes (C1, C2) possédant une borne commune (g) directement connectée à la grille du transistor principal (M1), la valeur capacitive de la deuxième capacité (C2) étant supérieure à la somme de la valeur capacitive de la première capacité (C1) et de la valeur capacitive de la capacité grille/source (Cg) du transistor principal.

## Description

L'invention concerne la mémorisation électrique non volatile d'un bit et les mémoires correspondantes, plus particulièrement les mémoires mortes programmables et effaçables électriquement (EEPROM).

L'homme du métier sait qu'il existe plusieurs types de mémoires. On peut citer notamment les mémoires à accès aléatoire (RAM: "Random Access Memory" en langue anglaise). En d'autres termes, on peut atteindre n'importe quel point de la mémoire, directement grâce à son adresse. Une mémoire à accès aléatoire dite "mémoire vive" est une mémoire dans laquelle on peut inscrire, lire ou effacer les informations autant de fois qu'on le désire, mais qui ne conserve pas l'information mémorisée lors d'une coupure d'alimentation.

D'autres types de mémoires dites "mortes" ou non volatiles conservent l'information mémorisée lors d'une coupure d'alimentation.

Plus particulièrement les mémoires ROM ("Read Only Memory" en langue anglaise) sont des mémoires mortes dans lesquelles l'information est enregistrée une fois pour toute au cours de leur fabrication. Elles ne peuvent qu'être lues et ne peuvent en aucun cas être modifiées.

Les mémoires PROM ("Programmable Read Only Memory" en langue anglaise) sont des mémoires mortes programmables électriquement une seule fois par l'utilisateur, par exemple au moyen de la rupture d'un fusible. Ces mémoires sont réalisées en technologie bipolaire ou en technologie MOS : ("Métal-Oxyde-Silicium" en langue anglaise) c'est-à-dire à base de transistors à effet de champ à grilles isolées.

Les mémoires EPROM et EEPROM sont deux autres types de mémoire non volatiles.

Plus précisément, la mémoire EPROM ("Electrically Programmable Read Only Memory" en langue anglaise) est une mémoire morte programmable électriquement et effaçable aux rayons ultraviolets tandis que la mémoire EEPROM ("Electrically Erasable Programmable Read Only Memory" en langue anglaise) est une mémoire morte programmable et effaçable électriquement c'est-à-dire qu'il n'est plus nécessaire de débrancher la mémoire du circuit pour l'effacer et la reprogrammer.

Actuellement, les mémoires EEPROM comprennent un transistor à effet de champ à grille isolée comportant une grille flottante supplémentaire en silicium polycristallin qui n'est pas reliée au circuit extérieur. Cette grille flottante est surmoulée par la grille de commande normale du transistor. La grille flottante est séparée du substrat du transistor par une première couche diélectrique d'oxyde de silicium tandis que la grille de commande est séparée de la grille flottante par une deuxième couche diélectrique d'oxyde de silicium.

Plus précisément, la grille flottante (c'est-à-dire non connectée extérieurement) stocke les charges de façon non volatile tandis que la grille de commande contrôle l'injection depuis le canal normal du transistor MOS vers la grille flottante en attirant les électrons du canal au travers l'oxyde de grille par un effet bien connu de l'homme du métier sous la dénomination "d'effet tunnel". Les électrons sont alors piégés dans la grille flottante et comme cette dernière est parfaitement isolée, elle ne peut se décharger. On obtient donc une mémoire non volatile dont la charge est garantie en général dix ans à 70°C.

L'effet tunnel est obtenu lorsqu'une différence de tension importante est appliquée entre la grille flottante et le drain du transistor, différence de tension dépendant du potentiel appliqué sur la grille de commande et sur le drain et provoquant un faible courant de conduction dans la couche isolante d'oxyde de la capacité flottante (ce courant d'effet tunnel disparaît lorsque la différence de tension aux bornes de la capacité chute). Cependant, l'épaisseur de la couche d'oxyde située entre la grille flottante et le substrat joue également un rôle prépondérant dans l'apparition de l'effet tunnel. Généralement, cet effet tunnel apparaît pour des champs électriques supérieurs à 1 volt/nm. Aussi, afin d'éviter d'appliquer des différences de tension très élevées, risquant de provoquer la destruction du transistor, il a été nécessaire de développer des technologies spécifiques pour la fabrication de telles mémoires EEPROM.

L'une des difficultés à vaincre pour réaliser de telles mémoires réside dans l'obtention de couches minces d'oxyde d'une qualité parfaite. Actuellement, on réalise, sous la grille flottante, une couche d'oxyde de grille ayant une épaisseur classique de quelques dizaines de nanomètres sauf en une région spécifique, située entre le drain et la grille flottante, au niveau de laquelle l'épaisseur de la couche d'oxyde de grille est de l'ordre de quelques nanomètres. C'est donc au niveau de cette région spécifique, formant le point mémoire, que se produira l'effet tunnel, typiquement sous une tension de l'ordre d'une dizaine de volts.

Il apparaît donc que les technologies de fabrication dédiées EEPROM nécessitent des étapes supplémentaires par rapport à des technologies CMOS standard (à base de transistors complémentaires à effet de champ à grilles isolées) pour permettre l'intégration des cellules de mémoire EEPROM, notamment pour permettre la réalisation de la couche d'oxyde localement, voire totalement amincie. Cette complexité de fabrication induit donc un coût supplémentaire et ne permet pas d'être réalisée en utilisant des technologies de fabrication CMOS classiques.

L'invention vise à apporter une solution à ce problème.

Un but de l'invention est de permettre l'intégration des cellules de mémoire EEPROM dans une technologie CMOS standard, sans que cette intégration nécessite des caractéristiques supplémentaires de fabrication par rapport à la technologie de fabrication CMOS standard. De ce fait l'invention a pour but d'utiliser un transistor classique à effet de champ à grille isolée c'est-à-dire présentant notamment une couche d'oxyde grille d'épaisseur constante, tout en supportant des tensions génératrices d'effet tunnel, très élevées, et bien supérieures à la tension de claquage du transistor.

Il est à noter ici que, au sens de la présente invention, et à des fins de simplification, l'expression "effet tunnel" englobe la notion de génération d'un courant dans une couche isolante d'une capacité, mais aussi la notion d'injection de porteurs chauds (particules ayant une charge électrique et une vitesse élevées) dans une couche isolante d'une capacité.

L'invention propose donc un procédé de mémorisation électrique non volatile d'un bit. Selon une caractéristique générale de l'invention, on réalise au sein d'un substrat semi-conducteur un transistor à effet de champ à grille isolée encaissonné dans le substrat semi-conducteur, ainsi qu'une première et une deuxième capacités ayant une borne commune directement connectée à la grille du transistor. On choisit les valeurs capacitives des différentes capacités de façon à ce que la valeur capacitive de la deuxième capacité soit supérieure à la somme de la valeur capacité de la première capacité et de la valeur capacitive de la capacité grille/source du transistor et, pour la mémorisation d'un bit ayant une première valeur logique, par exemple la valeur "1", on génère un effet tunnel dans la première capacité, tandis que pour la mémorisation d'un bit ayant une deuxième valeur logique, par exemple la valeur "0", on génère un effet tunnel dans la première capacité et dans la capacité grille/source du transistor.

On réalise avantageusement le transistor avec une couche d'oxyde de grille sensiblement constante, par exemple de l'ordre de 25 nanomètres pour une technologie CMOS standard 1,5 µ, et on génère l'effet tunnel en appliquant sur la source du transistor une tension d'écriture supérieure à la tension de claquage ou de destruction du transistor, typiquement une tension d'écriture de l'ordre de 40 volts, tout en connectant le drain du transistor en l'air.

Une observation à base de l'invention réside dans le fait que, bien que dans les technologies CMOS modernes, les transistors puissent supporter des tensions allant jusqu'à 5, voire 7 volts, la technologie elle-même peut supporter des tensions beaucoup plus élevées, notamment au niveau de la jonction PN entre le caisson dans lequel est réalisé un transistor, et le substrat dans lequel est situé le caisson. De ce fait, bien que le transistor selon l'invention puisse être un transistor PMOS (ou NMOS) classique, et qu'il ne peut par conséquent supporter que des différences de tension de l'ordre de 5 volts entre ces électrodes, les tensions absolues des électrodes du transistor mesurées par rapport au substrat peuvent être beaucoup plus élevées puisque ce transistor est encaissonné dans un substrat semi-conducteur, c'est-à-dire qu'il est réalisé dans un caisson semi-conducteur ayant un type de conductivité opposé à celui du substrat dans lequel se situe le caisson. Ainsi, dans le cas où l'on utilise un transistor à effet de champ à grille isolée à canal P (transistor PMOS) ce transistor sera réalisé dans un caisson de type N situé dans un substrat semi-conducteur de type P. Dans le cas où l'on utilise un transistor à canal N (transistor NMOS), le caisson du transistor sera de type P tandis que le substrat semi-conducteur sèra de type N.

En outre, en raison notamment de la relation existant entre les valeurs capacitives des différentes capacités, la première capacité ne voit la tension d'écriture élevée que lorsqu'il est nécessaire de générer l'effet tunnel lors de la programmation d'un 1 par exemple. Par contre, au cours de la programmation de l'autre valeur logique du bit, par exemple un "0", la capacité grille/source du transistor se trouve alors en parallèle avec la première capacité et voit donc la même tension d'écriture. En conséquence, une partie du courant résultant de l'effet tunnel sera générée par la première capacité et une autre partie de ce courant sera générée par la capacité grille/source du transistor.

L'invention a également pour objet un dispositif de mémoire morte programmable et effaçable électriquement, comprenant au moins une cellule de mémorisation programmable et effaçable par effet tunnel, cette cellule comportant un transistor principal relié à un circuit capacitif. Selon une caractéristique générale de l'invention, le transistor principal est encaissonné dans un substrat semi-conducteur et le circuit capacitif comporte une première et une deuxième capacités distinctes possédant une borne commune directement connectée à la grille du transistor principal, la valeur capacitive de la deuxième capacité étant supérieure à la somme de la valeur capacitive de la première capacité et de la valeur capacitive de la capacitive grille/source du transistor principal.

Selon un mode de réalisation de l'invention, la cellule de mémorisation comporte une borne d'entrée reliée à la source et au caisson du transistor principal, pour recevoir sélectivement une tension d'écriture choisie, par exemple 40 volts, ou une tension de lecture choisie, par exemple 5 volts, inférieure à la tension d'écriture. La cellule de mémorisation comporte également une première et deuxième bornes auxiliaires pour recevoir une tension auxiliaire, par exemple 0 volt, inférieure aux tensions d'écriture et de lecture, ainsi qu'une borne de sortie. Il est en outre prévu une première résistance connectée entre l'autre borne de la première capacité, différente de ladite borne commune, et la borne d'entrée, ainsi qu'une deuxième résistance connectée entre l'autre borne de la deuxième capacité, différente de ladite borne commune, et la borne d'entrée. La cellule de mémorisation comporte également un premier interrupteur, commandable par un signal de commande d'écriture, connecté entre ladite autre borne de la première capacité et la première borne auxiliaire, un deuxième interrupteur, commandable par un signal de commande d'écriture, connecté entre ladite autre borne de la deuxième capacité et la deuxième borne auxiliaire, et un troisième interrupteur, commandable par un signal de commande de lecture, connecté entre le drain du transistor et la borne de sortie.

Le dispositif de mémoire selon l'invention comprend par ailleurs avantageusement un quatrième interrupteur connecté entre la première borne auxiliaire et la masse, ainsi qu'un cinquième interrupteur connecté entre la deuxième borne auxiliaire et la masse. Les quatrième et cinquième interrupteurs sont respectivement commandés de façon antagoniste selon la valeur logique du bit à écrire, par deux signaux de commande de donnés. En d'autres termes, selon la valeur logique du bit à écrire, l'un de ses interrupteurs sera fermé tandis que l'autre sera ouvert et inversement.

Afin de détecter un courant de drain, lors de la lecture du dispositif de mémoire, une troisième résistance est avantageusement connectée entre la borne de sortie et la masse.

Bien que l'on puisse réaliser les première et deuxième capacités en superposant, sur une couche épaisse d'oxyde deux couches de polysilicium séparées par une couche d'oxyde de silicium, les première et deuxième capacités sont avantageusement réalisées par des transistors auxiliaires à effet de champ à grilles isolées également encaissonnés dans le substrat semi-conducteur. Les épaisseurs des couches d'oxyde de grille du transistor principal et des transistors auxiliaires sont alors sensiblement égales, par exemple de l'ordre de 25 nm.

Le dispositif selon l'invention peut également comprendre une matrice de cellules de mémorisation, commandable ligne par ligne en ce qui concerne les commandes d'écriture et de lecture, et commandable colonne par colonne en ce qui concerne la valeur logique des bits à écrire et à lire. De ce fait, cette commande croisée ligne-colonne permet de commander chaque cellule individuellement, que ce soit pour l'écriture d'un "1" logique, pour l'écriture d'un "0" logique, ou pour la lecture d'une cellule particulière. L'invention permet donc de réaliser ici une matrice de cellules de programmation qui offre l'avantage, contrairement aux matrices de l'art antérieur, de pouvoir programmer par exemple sélectivement un "0" dans une cellule particulière sans être au préalable contraint, comme dans l'art antérieur, d'effacer toute une ligne c'est-à-dire d'écrire un "0" dans toute une ligne, puis d'écrire des "1" dans les cellules dans lesquelles on ne souhaite pas d'écrire un "0".

Selon un mode de réalisation de l'invention, les bornes d'entrée de toutes les cellules sont reliées ensemble. Les première et deuxième bornes auxiliaires ainsi que les bornes de sortie de toutes les cellules sont respectivement reliées ensemble. Le dispositif comprend en outre, pour chaque ligne de la matrice, un unique moyen de commande apte à délivrer les signaux de commande d'écriture et de lecture à tous les premiers, deuxièmes et troisièmes interrupteurs des cellules de ladite ligne, et, pour chaque colonne de la matrice, une unique résistance connectée entre les bornes de sortie et la masse ainsi qu'un unique moyen de commande apte à délivrer les signaux de commande de données valables pour toutes les cellules de la colonne.

L'invention a également pour objet un procédé de commande d'un dispositif tel que défini précédemment, procédé dans lequel on applique au caisson du transistor principal une tension de caisson supérieure ou égale à la tension de source du transistor principal dans le cas d'un transistor à canal P, et inférieure ou égale à la tension de source du transistor principal dans le cas d'un transistor à canal N. On évite ainsi la création d'une jonction PN passante entre la source et le caisson. Cette application au caisson d'une telle tension de caisson, peut être avantageusement obtenue en reliant la source du transistor principal à l'électrode de caisson.

Selon ce procédé, en phase d'écriture, on applique à la source du transistor principal une tension d'écriture choisie, on connecte le drain du transistor principal en l'air et on applique la tension d'écriture à l'autre borne de l'une des deux capacités, différente de ladite borne commune, tandis qu'on applique une tension auxiliaire, par exemple la masse, inférieure à la tension d'écriture à l'autre borne de l'autre capacité, et vice versa selon la valeur logique du bit à écrire.

En phase de lecture, on applique avantageusement à la source du transistor principal ainsi qu'aux deux autres bornes des deux capacités une tension de lecture comprise entre ladite tension auxiliaire et ladite tension d'écriture, par exemple 5 volts, et on connecte le drain du transistor principal à la borne de sortie de façon à permettre la détection éventuelle d'un courant de drain.

D'autres avantages et caractéristiques de l'invention apparaîtront à l'examen de la description détaillée de modes de réalisation et de mise en oeuvre de l'invention, nullement limitatifs, et des dessins annexés, sur lesquels :
- la figure 1 est un synoptique schématique d'une cellule de mémorisation selon l'invention,
- la figure 2 illustre plus en détail une réalisation particulière de certains éléments de la cellule de la figure 1,
- la figure 3 illustre schématiquement une réalisation partielle de la cellule de la figure 1, au sein d'un substrat semi-conducteur,
- la figure 4 illustre la configuration de la cellule de la figure 1 pour l'écriture d'un "0" logique,
- la figure 5 illustre schématiquement la configuration de la cellule de la figure 1 en phase de lecture et,
- la figure 6 illustre schématiquement une matrice de cellules de mémorisation selon l'invention.

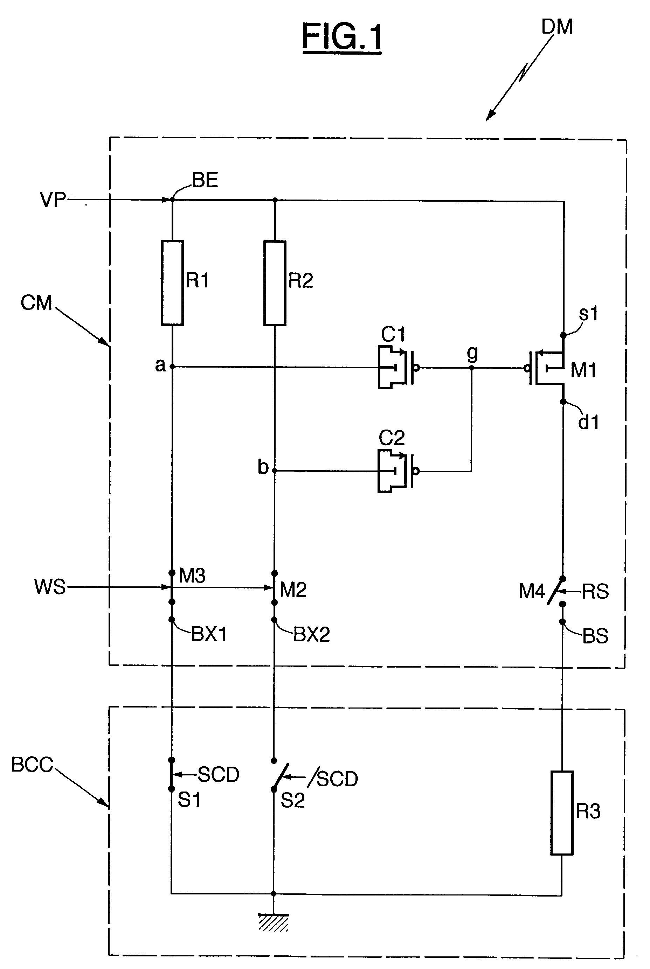

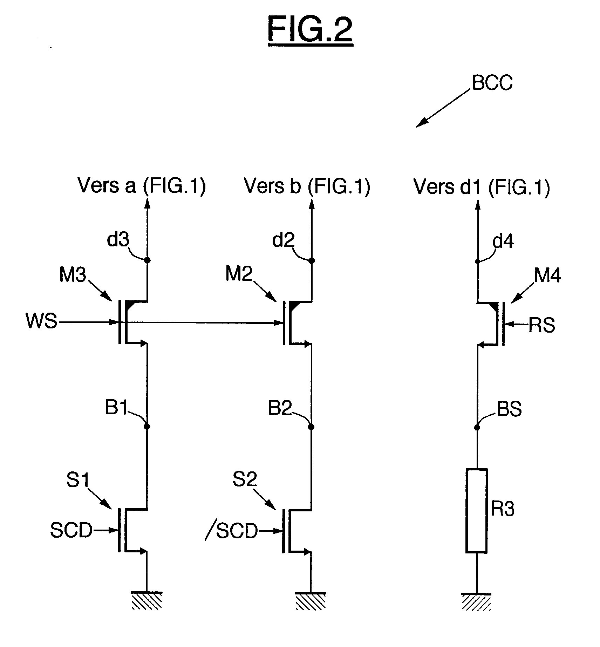

Tel qu'illustré sur la figure 1, le dispositif de mémoire DM selon l'invention comporte une cellule de mémorisation CM articulée autour d'un transistor principal M1 à effet de champ à grille isolée. Dans l'exemple décrit, ce transistor M1 est un transistor à canal P (transistor PMOS). La source sl de ce transistor est reliée à une borne d'entrée BE tandis que son drain dl est relié à une borne de sortie BS par l'intermédiaire d'un interrupteur M4 commandable par un signal de commande de lecture RS.

La grille de ce transistor M1 est directement connectée à deux capacités C1 et C2. Sur la figure 1, la référence g désigne la borne commune des deux capacités C1 et C2 reliées directement à la grille du transistor M1. Une telle connexion directe signifie selon l'invention qu'il n'existe aucune autre connexion entre le noeud g et un autre noeud du circuit.

Les capacités C1 et C2 sont ici formées par les capacités grille/caisson de deux transistors auxiliaires PMOS encaissonnés, dont le drain, la source et le caisson sont reliés ensemble.

Cette borne commune drain-source-caisson "a" de la capacité C1 est reliée à la borne d'entrée BE par l'intermédiaire d'une première résistance R1 tandis que la borne commune homologue "b" du transistor C2 est reliée à la borne d'entrée BE par l'intermédiaire d'une deuxième résistance R2.

La borne "a" est par ailleurs reliée à une première borne auxiliaire BX1 par l'intermédiaire d'un interrupteur M3 tandis que la borne commune "b" est reliée à une deuxième borne auxiliaire BX2 par l'intermédiaire d'un autre interrupteur M2. Les deux interrupteurs M2 et M3 sont commandables tous deux par le même signal de commande d'écriture WS.

Les deux bornes auxiliaires BX1 et BX2 sont respectivement reliées à la masse par l'intermédiaire de deux interrupteurs S1 et S2 commandés de façon antagoniste par deux signaux de commande de données SCD et /SCD (l'annotation /SCD signifiant que ce signal est le complémentaire du signal SCD).

Les interrupteurs S1 et S2 font partie d'un bloc BCC, externe à la cellule de mémorisation CM, qui comporte par ailleurs une troisième résistance R3 connectée entre la borne de sortie BS et la masse. Comme on le verra plus en détail ci-après, cette résistance R3 permettra de limiter la valeur d'un courant de drain éventuel détecté lors d'une lecture de la mémoire.

Ainsi qu'il sera expliqué plus en détail ci-après, la tension d'entrée VP, disponible sur la borne d'entrée BE, peut atteindre des valeurs élevées lors de l'écriture dans la cellule CM, typiquement des valeurs de l'ordre de 40 volts. Dans ces conditions, les interrupteurs M2, M3 et M4 doivent pouvoir supporter de telles tensions. Une solution consiste à réaliser ces interrupteurs à partir de transistors à effet de champ à grille isolée à double diffusion (bien connus de l'homme du métier sous la dénomination DMOS). En l'espèce, il s'agit ici de transistors à canal N (transistors NDMOS) puisque le transistor principal M1 est à canal P. Ces transistors NDMOS peuvent supporter une tension élevée au niveau de leur drain.

Les interrupteurs S1 et S2 peuvent quant à eux être réalisés par des transistors MOS classiques, par exemple à canal N.

Plus précisément, comme illustré sur la figure 2, les drains d2 et d3 des transistors M2 et M3 sont respectivement reliés aux bornes "b" et "a" de la figure 1 tandis que leurs sources sont respectivement connectées aux bornes auxiliaires BX1 et BX2 elles-mêmes reliées aux sources des transistors S1 et S2. Les drains de ces derniers transistors sont directement connectés à la masse. Le signal de commande d'écriture WS est délivré sur la grille des transistors M3 et M2 tandis que les signaux de commande SCD et/SCD sont respectivement délivrés sur les grilles des transistors S1 et S2. D'une façon analogue le drain d4 du transistor M4 est relié au drain dl du transistor M1 tandis que la source de ce transistor M4 est reliée à la borne de sortie BS, elle-même reliée à la masse par l'intermédiaire de la résistance R3. Le signal de commande de lecture RS est délivré sur la grille du transistor M4.

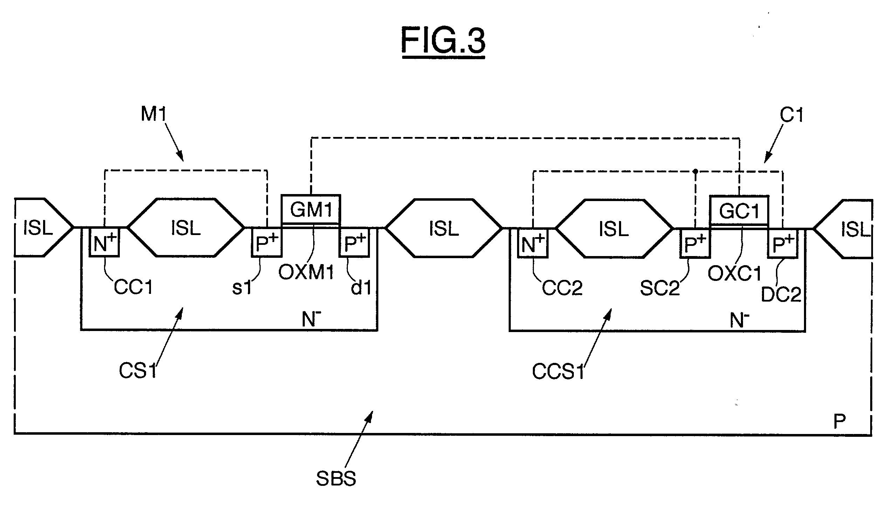

Sur la figure 3 on a représenté très schématiquement une partie de la cellule de mémorisation de la figure 1, réalisée selon une technologie intégrée CMOS, par exemple une technologie CMOS 1,5 µ (1,5 µ désignant la largeur des canaux des transistors, c'est-à-dire la distance drain source).

Plus précisément, sur cette figure 3 n'ont été représentés que le transistor M1 et l'une des deux capacités, à savoir la première capacité C1. Par ailleurs, à des fins de simplification, seuls les éléments essentiels de ces structures intégrées ont été représentés sur la figure 3. C'est le cas notamment des régions de grille, de drain, de source et des régions d'isolement latérales. Cependant, les espaceurs des transistors non volontairement pas été représentés. De même, les différentes métallisations ainsi que les liaisons entre ces métallisations ont été simplement représentées sur cette figure 3 par des tiretés.

Comme on peut le voir sur cette figure, le transistor principal M1 est réalisé dans un caisson semi-conducteur CS1, dopé N⁻. Ce caisson CS1 a été lui-même réalisé au sein d'un substrat semi-conducteur SBS dopé P. Le caisson semi-conducteur CS1 est isolé latéralement par deux zones d'isolement ISL par exemple des zones du type LOCOS selon une dénomination bien connue de l'homme du métier. Dans ce caisson semi-conducteur CS1 ont été implantées deux régions dopées P⁺ formant respectivement les régions de source s1 et de drain d1 du transistor M1. Entre ces régions de source et de drain se situe la grille GM1 du transistor M1 séparée du caisson CS1 par une couche d'oxyde de grille OXM1. Enfin, la région de source s1 est séparée d'une prise de contact de caisson, dopée N⁺, et référencée CC1, par une zone d'isolement latéral ISL.

Le transistor auxiliaire dont la capacité entre la grille GC1 et le caisson CCS1 matérialise la capacité C1, est réalisé d'une façon analogue au transistor M1.

En ce qui concerne les connexions entre les électrodes de ces transistors, la source sl du transistor M1 est reliée à la zone de contact caisson CC1. Il en est de même entre la source SC2 du transistor auxiliaire et le contact de caisson CC2. Par ailleurs, la source SC2 et le drain DC2 de ce transistor auxiliaire sont reliés ensemble et la grille GC1 de ce transistor auxiliaire C1 est reliée à la grille GM1 du transistor M1.

Bien entendu, la deuxième capacité C2 de la cellule de mémorisation est réalisée de façon analogue à la première capacité C1 à partir d'un transistor auxiliaire qui serait disposé à côté du transistor auxiliaire matérialisant la capacité C1. La grille de ce deuxième transistor auxiliaire est alors bien évidemment reliée à la grille GC1 et à la grille GM1.

Il convient de remarquer ici que la jonction PN réalisée entre le substrat SBS et les caissons de chacun de ces transistors principal et auxiliaire peut supporter une tension allant jusqu'à 50 volts environ. En conséquence l'application d'une telle tension élevée sur le contact d'un caisson d'un transistor ne provoquera pas de dégradation irréversible de la structure semi-conductrice.

Dans l'exemple décrit ici, les différents oxydes de grille OXM1 et OXC1 des différents transistors réalisés en technologie CMOS 1,5 µ ont une épaisseur sensiblement constante de l'ordre de 25 nm. La deuxième capacité C2 présente une valeur capacitive de l'ordre de 0,1pF. Le rapport entre la valeur capacitive de la première capacité C1 et celle de la deuxième capacité C2 est de l'ordre 1/10ème tandis que le rapport entre la valeur capacitive de la capacité grille/source du transistor principal M1 et la valeur capacitive de la deuxième capacité C2 est de l'ordre de 1/20ème. L'homme du métier aura naturellement compris que puisque les oxydes de grille sont sensiblement égaux, c'est le rapport des surfaces des grilles des différents transistors qui permettra d'établir les différents rapports entre ces valeurs capacitives.

On va maintenant décrire en détail de fonctionnement de la cellule de mémorisation selon l'invention, en se référant plus particulièrement aux figures 1, 4 et 5.

Sur la figure 1, le dispositif de mémoire DM a été configuré pour l'écriture dans la cellule de mémorisation d'un bit ayant une première valeur logique, par exemple la valeur 1.

Dans cette configuration, par application du signal de commande d'écriture WS, les interrupteurs M2 et M3 sont fermés (transistors M2 et M3 conducteurs) tandis que l'interrupteur M4 est ouvert (signal de commande de lecture inactif) c'est-à-dire que le transistor M4 est bloqué. En d'autres termes, le drain dl du transistor principal M1 est alors connecté en l'air c'est-à-dire qu'il n'existe aucune connexion entre le drain dl et un autre noeud du circuit permettant la circulation d'un éventuel courant de drain.

Par ailleurs, sous l'action des signaux de commande de données complémentaires SCD et /SCD, les interrupteurs S1 et S2 sont respectivement fermé et ouvert (transistor S1 conducteur et transistor S2 bloqué).

Les différents signaux de commande WS, RS, SCD, /SCD sont délivrés, sous la forme de tensions de 0 volt ou 5 volts, par des moyens externes classiques non représentés ici à des fins de simplification et commandés par exemple par l'unité centrale d'un microprocesseur.

Une tension d'écriture VP de l'ordre de 40 volts est appliquée sur la borne d'entrée BE de la cellule de mémorisation CM. Puisque les interrupteurs M3 et S1 sont fermés (application d'une tension de 5 volts sur les grilles de ces transistors) une tension auxiliaire nulle est appliquée à la borne BX1 de la cellule de mémorisation et par conséquent à la borne "a" de la capacité C1.

Par contre, comme l'interrupteur M2 est fermé et que l'interrupteur S2 est ouvert (application d'une tension nulle sur la grille du transistor correspondant), une tension de l'ordre de 40 volts est également appliquée à la borne "b" de la capacité C2.

Puisque l'interrupteur M4 est ouvert (drain dl en l'air) la tension au niveau du drain dl du transistor M1 est sensiblement la même que celle appliquée sur la source sl c'est-à-dire également 40 volts. En raison de la division capacitive, la tension au noeud g est donc également de l'ordre de 40 volts. En conséquence, les différences de potentiel entre les électrodes de ce transistor M1 sont pratiquement nulles. La seule différence de potentiel importante, de l'ordre de 40 volts, est appliquée entre le contact de caisson du transistor M1 et le substrat semi-conducteur SBS qui, compte tenu de la technologie employée, supporte une telle différence de potentiel sans dégradation de structure.

En raison de la différence de potentiel importante entre le noeud "g" et le noeud "a", un effet tunnel se produit dans la capacité C1 provoquant une chute de tension au noeud "g" qui voit sa tension diminuer de quelques volts (typiquement 2 ou 3 volts) jusqu'à l'arrêt de l'effet tunnel. A ce moment-là la tension au noeud "g" est de l'ordre de 37 à 38 volts.

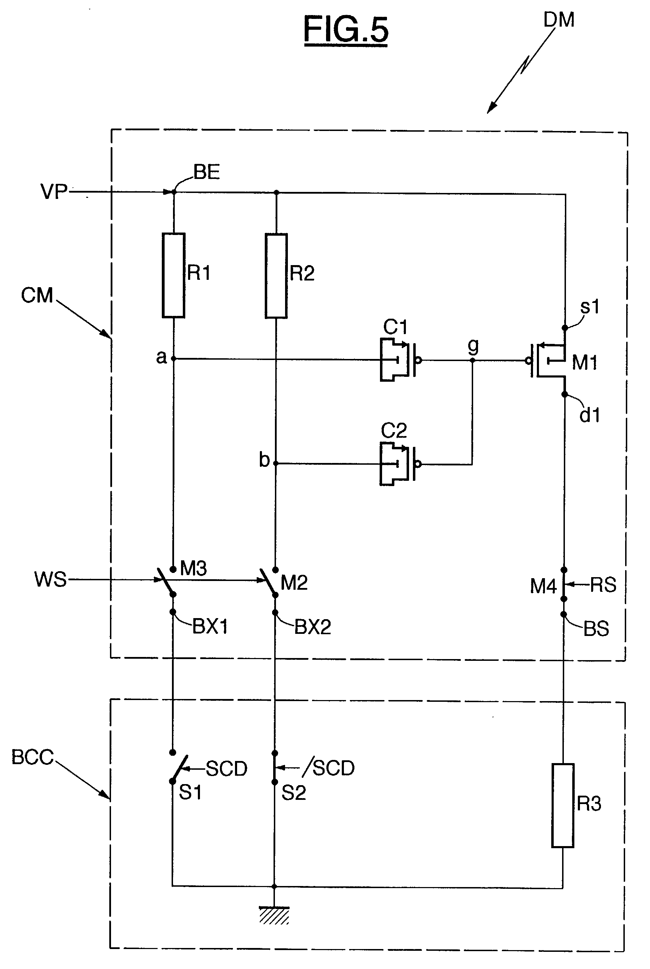

En phase de lecture (figure 5) la tension de lecture VP est égale à 5 volts et le signal WS est mis à l'état bas ce qui a pour effet de bloquer les transistors M2 et M3 et d'ouvrir donc les interrupteurs correspondants. Simultanément, le signal RS est mis à l'état haut (application d'une tension de 5 volts sur la grille du transistor M4 et fermeture de l'interrupteur correspondant). Il est à noter que dans cette configuration, la position des interrupteurs S1 et S2 est sans importance. L'application d'une tension de lecture VP de 5 volts sur la borne d'entrée BE de la cellule de mémorisation, a pour effet de porter les noeuds "a" et "b" également à la tension de 5 volts environ. De par la chute de tension au niveau du noeud "b", passant de 40 volts à 5 volts, la tension au noeud "g" chute également de l'ordre de 35 volts pour atteindre une valeur de l'ordre de 2 à 3 volts. En conséquence, puisque la tension sur la source sl du transistor M1 est de l'ordre 5 volts, le transistor M1 est alors conducteur ce qui provoque le passage d'un courant de drain dans la résistance R3, courant de drain par exemple détectable au niveau de la borne de sortie BS, et synonyme de la lecture d'un "1" mémorisé.

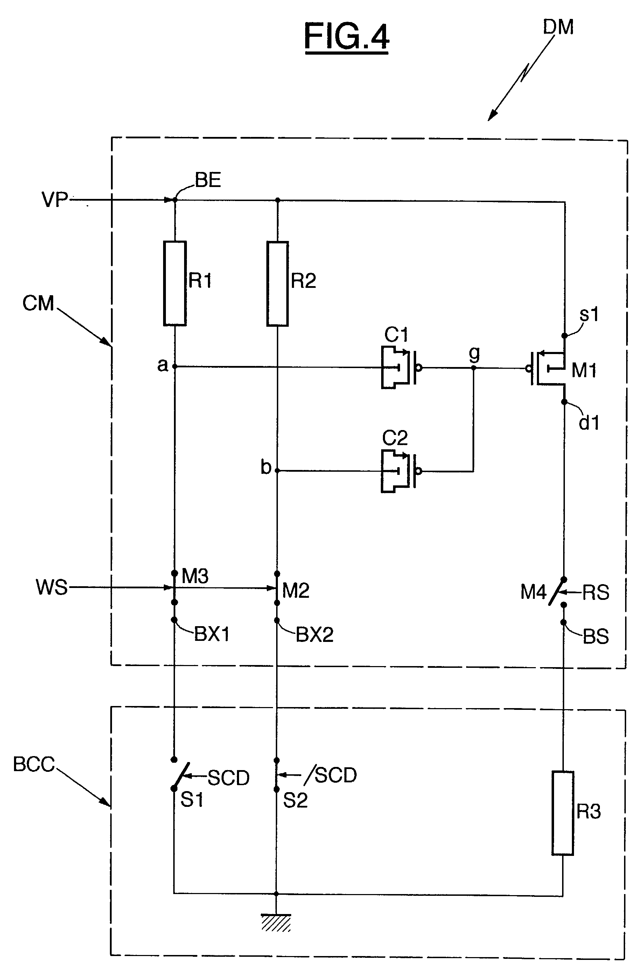

Pour l'effacement de la mémoire, ou ce qui est équivalent dans le cas présent à la mémorisation d'un "0", on configure le dispositif de mémoire DM comme illustré sur la figure 4. Plus précisément, la seule différence entre cette configuration et celle de la figure 1 réside dans le fait que sur la figure 4, c'est cette fois-ci l'interrupteur S2 qui est fermé et l'interrupteur S1 qui est ouvert. En conséquence, la tension au noeud "b" est de l'ordre de 0 volt tandis que la tension au noeud "a" est de l'ordre de 40 volts. Compte tenu de la division capacitive, la tension au noeud "g" est aussi de l'ordre de 0 volt. En conséquence, la tension au borne de la capacité C1 est de l'ordre de -40 volts et l'effet tunnel va se produire dans le transistor C1. De même, compte tenu de la différence de potentiel de l'ordre de 40 volts entre la source et la grille du transistor M1, un effet tunnel va également se produire dans ce transistor M1. Ces deux effets tunnel vont avoir pour conséquence de faire croître la tension au noeud "g" de quelques volts (typiquement de l'ordre de 2 à 3 volts) jusqu'à l'arrêt de l'effet tunnel.

En ce qui concerne le transistor M1, l'homme du métier aura remarqué que, bien qu'il existe une différence de potentiel importante (de l'ordre de 40 volts) entre la source et la grille de transistor d'une part, et entre le drain et la grille de ce transistor d'autre part, cette différence de potentiel est non destructive pour le transistor car, mise à part le courant généré par effet tunnel se produisant entre la source et la grille, aucun autre courant ne circule dans le transistor M1 en raison de la connexion en l'air du drain dl (interrupteur M4 ouvert).

En phase de lecture (figure 5), compte tenu de la tension de 5 volts appliquée aux noeuds "a", "b" et sur la source sl du transistor M1, la tension au noeud "g" augmente jusqu'à environ 7 à 8 volts. Compte tenu du fait que la tension de source du transistor M1 est de l'ordre de 5 volts, celui-ci est par conséquent bloqué et aucun courant de drain ne circule dans la résistance R3. L'absence de la détection de la circulation d'un courant de drain est donc synonyme de la lecture d'un "0".

Un calcul simple montre que les conditions minimales, que doivent respecter les différences valeurs capacitives pour obtenir notamment les tensions souhaitées au noeud "g", se résument
- à une valeur capacitive C1 de la première capacité inférieure à la différence C2-Cg où Cg désigne la capacité grille/source du transistor M1, et
- à une capacité grille/source Cg inférieure à C2-C1.

En d'autres termes, la capacité C2 doit être supérieure à la somme C1+Cg.

Par ailleurs, le même calcul simple montre que la tension VP doit être choisie d'une façon générale de façon qu'elle soit supérieure à K1ΔV + K2Vₜᵤₙₙₑₗ où
K1 et K2 sont des coefficients dépendant des rapports C1/C2 et Cg/C2,
ΔV désigne la différence de tension grille/source suffisante pour obtenir soit un transistor M1 bloqué soit un transistor M1 conducteur (typiquement de l'ordre de 2 à 3 volts), et
Vₜᵤₙₙₑₗ désigne la tension minimale pour obtenir l'effet du tunnel dans les différentes capacités.

Compte tenu de la technologie employée ici (technologie CMOS 1,5 µ) conduisant à une épaisseur des oxydes de grille de l'ordre 25 mn, la tension Vₜᵤₙₙₑₗ est de l'ordre de 25 volts. Cependant, afin de ne pas devoir appliquer une tension VP trop élevée en écriture, il est préférable de choisir des rapports de capacité les plus faibles possibles. On choisira donc dans cet exemple de préférence un rapport C1/C2 de l'ordre de 1/10ème et un rapport Cg/C2 de l'ordre de 1/20ème.

Ceci étant, compte tenu des différents paramètres de la cellule réalisée (épaisseur d'oxydes, valeurs des capacités, technologie employée...) l'homme du métier pourra aisément choisi une tension VP convenable en écriture pour obtenir notamment l'effet tunnel recherché, et une tension VP en lecture convenable et compatible avec la technologie utilisée pour obtenir une conduction ou un blocage du transistor principal M1.

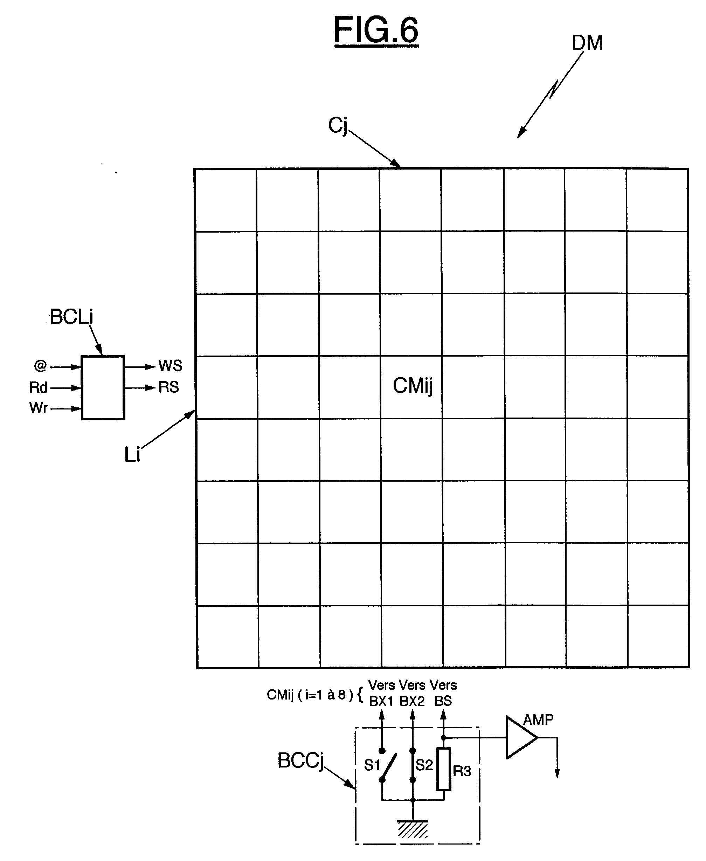

Sur la figure 6, on a représenté un dispositif de mémoire DM selon l'invention comportant une matrice de cellules de mémorisation CMij, où i désigne l'indice de ligne tandis que j désigne l'indice de colonne. On peut ainsi réaliser par exemple une mémoire EEPROM de 64 bits (8 x 8).

Dans cette matrice, toutes les bornes d'entrée BE des cellules CMij sont reliées ensemble, tandis que toutes les bornes BX1, BX2 et BS des cellules d'une même colonne Cj sont reliées ensemble. En outre toutes les grilles des transistors M2 et M3 des cellules d'une même ligne Li sont reliées ensemble et par conséquent activées par le même signal de commande d'écriture WS tandis que les grilles des transistors M4 de toutes les cellules CMij de la ligne Li sont également reliées ensemble et commandées par le même signal de commande de lecture RS.

En conséquence, le dispositif de mémoire DM comprend en outre pour chaque ligne Li un moyen de commande de ligne BCLi, affecté d'une adresse qui est par exemple le numéro de la ligne, et recevant en entrée un signal logique d'écriture Wr, un signal logique de lecture Rd ainsi qu'une information d'adresse @. Ce bloc BCLi délivre en sortie les signaux de commande WS et RS. Plus précisément, le signal WS sera actif (c'est-à-dire égal par exemple à 1) si le signal Wr est actif et si l'adresse reçue par le bloc BCLi correspond à l'adresse effective de ce bloc. De même, le signal RS sera actif si le signal Rd est actif et si l'adresse @ reçue correspond à l'adresse effective du bloc BCLi.

D'une façon analogue, à chaque colonne Cj de la matrice est affecté un bloc BCCj comportant les deux interrupteurs S1, S2 ainsi que la résistance R3. Il est en outre prévu, connecté à la borne de la résistance R3 de chaque bloc BCCj, un moyen d'amplification AMP permettant une détection aisée d'un courant éventuel de drain. Un unique moyen de commande, classique et non représenté ici à des fins de simplification, délivre donc les signaux SCD et /SCD au bloc BCCj qui permettront d'appliquer ou non la masse aux bornes auxiliaires BX1, BX2 de toutes les cellules de la colonne.

En conséquence, lorsque l'on souhaite écrire un mot dans une ligne de la mémoire DM, on porte la borne d'entrée commune de toutes les cellules de mémorisation à la tension d'écriture de 40 volts. On sélectionne le bloc BCLi de la ligne considérée au moyen de l'information d'adresse et l'on met le signal WS à l'état 1 pour toute la ligne considérée tandis que pour cette même ligne on met le signal RS à l'état zéro. On programme alors les différents bits du mot en agissant sur les interrupteurs S1 et S2 des différents blocs BCCj de la matrice.

Lorsqu'on veut lire les différents bits d'un mot de la mémoire, on applique une tension de lecture de 5 Volts sur l'ensemble des bornes d'entrée des cellules de mémorisation et on porte le signal RS à l'état 1 pour la ligne considérée (les signaux RS affectés aux autres lignes étant alors tous à zéro). Puis on détecte au niveau du bloc BCCj un courant éventuel de drain afin de déterminer si le bit lu est un "0" ou un "1".

L'invention a été plus particulièrement décrite en utilisant un transistor principal et des transistors auxiliaires PMOS ainsi que des transistors NDMOS (transistors M2, M3, M4) et NMOS (transistors S1, S2). Bien entendu, on peut réaliser la cellule de mémorisation CM dans un substrat SBS dopé N en utilisant cette fois-ci respectivement des transistors encaissonnés NMOS, ainsi que des transistors PDMOS et PMOS.

## Revendications

1. Procédé de mémorisation électrique non volatile d'un bit, caractérisé par le fait qu'on réalise au sein d'un substrat semi-conducteur (SBS) un transistor à effet de champ à grille isolée (M1) encaissonné dans le substrat semi-conducteur, ainsi qu'une première et une deuxième capacités (C1, C2) ayant une borne commune (g) directement connectée à la grille du transistor (M1), la valeur capacitive de la deuxième capacité (C2) étant supérieure à la somme de la valeur capacitive de la première capacité (C1) et de la valeur capacitive de la capacité grille/source (Cg) du transistor (M1), et, pour la mémorisation d'un bit ayant une première valeur logique (1), on génère un effet tunnel dans la première capacité (C1), tandis que pour la mémorisation d'un bit ayant une deuxième valeur logique (o), on génère un effet tunnel dans la première capacité (C1) et dans la capacité grille/source (Cg) du transistor (M1).

2. Procédé selon la revendication 1, caractérisé par le fait qu'on réalise le transistor (M1) avec une couche d'oxyde de grille (OXM1) sensiblement constante, et on génère l'effet tunnel en appliquant sur la source (s1) du transistor une tension d'écriture (VP) supérieure à la tension de claquage du transistor et en connectant le drain (dl) du transistor en l'air.

3. Dispositif de mémoire morte programmable et effaçable électriquement, comprenant au moins une cellule de mémorisation (CM) programmable et effaçable par effet tunnel comportant un transistor principal (M1) relié à un circuit capacitif, caractérisé par le fait que le transistor principal (M1) est encaissonné dans un substrat semi-conducteur (SBS), et par le fait que le circuit capacitif comporte une première et une deuxième capacités distinctes (C1, C2) possédant une borne commune (g) directement connectée à la grille du transistor principal (M1), la valeur capacitive de la deuxième capacité (C2) étant supérieure à la somme de la valeur capacitive de la première capacité (C1) et de la valeur capacitive de la capacité grille/source (Cg) du transistor principal.

4. Dispositif selon la revendication 3, caractérisé par le fait que la cellule de mémorisation (CM) comporte
une borne d'entrée (BE) reliée à la source et au caisson du transistor principal (M1), pour recevoir sélectivement une tension d'écriture choisie (VP) ou une tension de lecture choisie (VP), inférieure à la tension d'écriture, une première et une deuxième bornes auxiliaires (BX1, BX2) pour recevoir une tension auxiliaire inférieure aux tensions d'écriture et de lecture, et une borne de sortie (BS),
une première résistance (R1) connectée entre l'autre borne (a) de la première capacité, différente de ladite borne commune (g), et la borne d'entrée (BE), et une deuxième résistance (R2) connectée entre l'autre borne (b) de la deuxième capacité (C2), différente de ladite borne commune (g), et la borne d'entrée (BE),
un premier interrupteur (M3), commandable par un signal de commande d'écriture (WS), connecté entre ladite autre borne (a) de la première capacité et la première borne auxiliaire (BXa, un deuxième interrupteur (M2), commandable par le signal de commande d'écriture (WS), connecté entre ladite autre borne (b) de la deuxième capacité et la deuxième borne auxiliaire (BX2), et un troisième interrupteur (M4), commandable par un signal de commande de lecture (RS), connecté entre le drain (d1) du transistor principal (M1) et la borne de sortie (BS).

5. Dispositif selon la revendication 4, caractérisé par le fait qu'il comprend un quatrième interrupteur (s1) connecté entre la première borne auxiliaire (BX1) et la masse, un cinquième interrupteur (S2) connecté entre la deuxième borne auxiliaire (BS2) et la masse, les quatrième et cinquièmes inten-upteurs étant respectivement commandés de façon antagoniste selon la valeur logique du bit à écrire, par deux signaux de commande de données (SCD, /SCD).

6. Dispositif selon la revendication 4 ou 5, caractérisé par le fait qu'une troisième résistance (R3) est connectée entre la borne de sortie (BS) et la masse.

7. Dispositif selon l'une des revendications 3 à 6, caractérisé par le fait que l'épaisseur de la couche d'oxyde de grille (OXN1) du transistor principal est sensiblement constante.

8. Dispositif selon l'une des revendications 3 à 7, caractérisé par le fait que les première et deuxième capacités (C1, C2) sont réalisées par des transistors auxiliaires à effet de champ à grilles isolées réalisés dans des caissons semi-conducteurs situés dans un substrat semi-conducteur d'un type de conductivité opposé à celui des caissons, et par le fait que les épaisseurs des couches d'oxydes de grilles du transistor principal et des transistors auxiliaires sont sensiblement égales, par exemple de l'ordre de 25nm.

9. Dispositif selon l'une des revendications 3 à 8, caractérisé par le fait que le transistor principal et les transistors auxiliaires sont des transistors à canal P.

10. Dispositif selon les revendications 4 et 9, caractérisé par le fait que les premier, deuxième et troisième interrupteurs (M3, M2, M4) sont des transistors à effet de champ à grille isolée à double diffusion à canal N.

11. Dispositif selon l'une des revendications 3 à 10, caractérisé par le fait que la valeur capacitive de la première capacité (C1) est environ dix fois plus faible que la valeur capacitive de la deuxième capacité (C2), et la valeur capacitive de la capacité grille/source (Cg) du transistor principal est environ vingt fois plus faible que la valeur capacitive de la deuxième capacité (C2).

12. Dispositif selon l'une des revendications 3 à 11, caractérisé par le fait qu'il comprend une matrice de cellules de mémorisation (CMis), commandable ligne par ligne en ce qui concerne les commandes d'écriture et de lecture, et commandable colonne par colonne en ce qui concerne la valeur logique des bits à écrire et à lire.

13. Dispositif selon les revendications 4 et 12, caractérisé par le fait que les bornes d'entrée (BE) de toutes les cellules (CMij) sont reliées ensemble, par le fait que les premières et deuxièmes bornes auxiliaires ainsi que les bornes de sortie de toutes les cellules d'une même colonne sont respectivement reliées ensemble, par le fait que le dispositif comprend en outre, pour chaque ligne (Li) de la matrice, un unique moyen de commande (BCLi) apte à délivrer les signaux de commande d'écriture et de lecture à tous les premiers, deuxièmes et troisièmes interrupteurs des cellules de ladite ligne, et pour chaque colonne (Cj) de la matrice, une unique résistance (R3) connectée entre les bornes de sortie et la masse ainsi qu'un unique moyen de commande apte à délivrer les signaux de commande de données valables pour toutes les cellules de ladite colonne.

14. Procédé de commande d'un dispositif tel que défini dans l'une des revendications 3 à 13, dans lequel on applique au caisson (CS1) du transistor principal (M1) une tension de caisson (VP) supérieure ou égale à la tension de source (VP) du transistor principal dans le cas d'un transistor à canal P et inférieure ou égale à la tension de source du transistor principal dans le cas d'un transistor à canal N, et, en phase d'écriture, on applique à la source du transistor principal (M1) une tension d'écriture (VP) choisie, on connecte le drain du transistor principal (M1) en l'air et on applique la tension d'écriture à l'autre borne de l'une des deux capacités, différente de ladite borne commune (g), tandis qu'on applique une tension auxiliaire inférieure à la tension d'écriture à l'autre borne de l'autre capacité, différente de ladite borne commune, et vice-versa selon la valeur logique du bit à écrire.

15. Procédé selon la revendication 14, caractérisé par le fait que l'application de ladite tension auxiliaire à ladite autre borne consiste à relier ladite autre borne (a, b) à la masse.

16. Procédé selon la revendication 15, pour la commande d'un dispositif ayant un transistor principal dont l'épaisseur de la couche d'oxyde de grille est de l'ordre de 25 nm, la valeur capacitive de la première capacité (C1) étant environ dix fois plus faible que la valeur capacitive de la deuxième capacité (C2), et la valeur capacitive de la capacité grille/source (Cg) du transistor principal étant environ vingt fois plus faible que la valeur capacitive de la deuxième capacité (C2), caractérisé par le fait qu'on choisit une tension d'écriture (VP) de l'ordre de 40 volts.

17. Procédé selon l'une des revendications 14 à 16, caractérisé par le fait qu'en phase de lecture, on applique à la source (sl) du transistor principal ainsi qu'aux deux autres bornes (a, b) des deux capacités (C1, C2) une tension de lecture (VP) comprise entre ladite tension auxiliaire et la tension d'écriture, et on connecte le drain du transistor principal à la borne de sortie (RS) de façon à permettre la détection éventuelle d'un courant de drain.

18. Procédé selon la revendication 17, caractérisé par le fait qu'on choisit une tension de lecture (VP) de l'ordre de 5 volts.
